(19) Europäisches Patentamt

European Patent Office

Office européen des brevets

(11) **EP 1 438 721 B1**

(12) **EUROPÄISCHE PATENTSCHRIFT**

(45) Veröffentlichungstag und Bekanntmachung des Hinweises auf die Patenterteilung:
**15.11.2006 Patentblatt 2006/46**

(21) Anmeldenummer: **02774383.0**

(22) Anmeldetag: **17.09.2002**

(51) Int Cl.:
*G11C 11/16* (2006.01)    *G11C 11/15* (2006.01)

(86) Internationale Anmeldenummer:
**PCT/DE2002/003491**

(87) Internationale Veröffentlichungsnummer:
**WO 2003/034436 (24.04.2003 Gazette 2003/17)**

(54) **HALBLEITERSPEICHER MIT SICH KREUZENDEN WORT- UND BITLEITUNGEN, AN DENEN MAGNETORESISTIVE SPEICHERZELLEN ANGEORDNET SIND**

SEMICONDUCTOR STORAGE UNIT PROVIDED WITH INTERSECTING WORD AND BIT LINES WHEREON ARE ARRANGED MAGNETORESISTIVE MEMORY CELLS

MEMOIRE A SEMI-CONDUCTEURS DOTEE DE LIGNES DE MOTS ET DE BITS SE CROISANT SUR LESQUELLES SONT PLACEES DES CELLULES DE MEMOIRE MAGNETORESISTIVES

(84) Benannte Vertragsstaaten:
**DE FR GB IE IT NL**

(30) Priorität: **09.10.2001 DE 10149737**

(43) Veröffentlichungstag der Anmeldung:
**21.07.2004 Patentblatt 2004/30**

(73) Patentinhaber: **Infineon Technologies AG**
**81669 München (DE)**

(72) Erfinder: **SCHWARZL, Siegfried**
**85579 Neubiberg (DE)**

(74) Vertreter: **Epping - Hermann - Fischer**
**Ridlerstrasse 55**
**80339 München (DE)**

(56) Entgegenhaltungen:
**US-A- 5 477 482        US-A- 5 534 355**
**US-A- 5 600 297**

**Beschreibung**

Die vorliegende Erfindung betrifft einen Halbleiterspeicher mit sich kreuzenden Wort- und Bitleitungen, an denen magnetoresistive Speicherzellen angeordnet sind, sowie ein Verfahren und eine Schaltungsanordnung zum Bewerten des Informationsgehalts der Speicherzelle, wobei die magnetoresistive Speicherzelle eine Abfolge von Schichten bestehend aus wenigstens einer ersten magnetischen Schicht mit einer ersten Magnetisierungsachse, einer isolierenden Schicht und einer zweiten magnetischen Schicht mit einer zweiten Magnetisierungsachse umfaßt.

Nichtflüchtige Speicherzellen mit magnetoresistivem Widerstand - auch MRAM-Speicherzellen - genannt, weisen üblicherweise eine Schichtenfolge auf, die aus einer Kombination von ferromagnetischen Materialien und einer jeweils dazwischen liegenden Isolatorschicht besteht. Die Isolatorschicht wird auch als Tunneldielektrikum bezeichnet. Der Speichereffekt liegt dabei im magnetisch veränderbaren elektrischen Widerstand der Speicherzelle beziehungsweise der Speicherzellen.

Die ferromagnetischen Materialien besitzen je Schicht eine Magnetisierungsachse, welche parallel zueinander angeordnet sind, so daß sich zwei mögliche Einstellungen der Magnetisierungsrichtung je Schicht ergeben. In Abhängigkeit vom Magnetisierungszustand der Speicherzelle können die Magnetisierungsrichtungen in den magnetischen Schichten parallel oder antiparallel ausgerichtet sein. Je nach der relativen Ausrichtung zueinander weist die Speicherzelle einen unterschiedlichen elektrischen Widerstand auf. Dabei führt eine parallele Magnetisierungsrichtung zu einem niedrigeren elektrischen Widerstand in der Speicherzelle, während eine antiparallele Magnetisierungsrichtung zu einem höheren Widerstand führt.

In der Regel werden die Schichten derart ausgeführt, daß nur eine der beiden ferromagnetischen Schichten ihren Magnetisierungszustand unter dem Einfluß eines induzierten Magnetfeldes ändert, während die andere Schicht einen zeitlich unveränderlichen Zustand aufweist, sie dient also als Referenz-Magnetisierungsrichtung für die Zelle.

Die Isolatorschicht kann beispielsweise eine Dicke von etwa 1 bis 3 nm aufweisen. Die elektrische Leitfähigkeit durch dieses Schichtensystem wird wesentlich durch einen Tunneleffekt durch diese Isolatorschicht bestimmt. Variationen in der Tunnel-Isolatordicke führen zu starken Variationen in der Leitfähigkeit, da die Isolatordicke näherungsweise exponentiell in den Tunnelstrom eingeht.

Das Beschreiben einer solche Speicherzelle erfolgt über einen elektrischen Strom. Dazu ist die Speicherzelle derart aufgebaut, daß sie zwei sich kreuzende elektrische Leiter aufweist, im folgenden Wort- bzw. Bitleitung genannt. Am Kreuzungspunkt der Leiter ist jeweils eine wie oben beschriebene Schichtenfolge aus magnetischen Schichten und Tunneldielektrikums-Schichten vorgesehen. Durch die beiden Leiter fließt ein elektrischer Strom, der jeweils ein magnetisches Feld erzeugt. Das magnetische Feld, das durch Überlagerung dieser Felder entsteht, wirkt auf die einzelnen magnetischen Schichten. Wenn die magnetische Feldstärke jeweils ausreichend groß ist, werden die dem Feld ausgesetzten magnetischen Schichten ummagnetisiert.

Als Auslesemethoden für eine Bewertung des Speicherzelleninhaltes kommen mehrere Möglichkeiten in Betracht. Beispielsweise kann eine direkte Bewertung des Zellwiderstandes und gegebenenfalls ein anschließender Vergleich mit einem Referenzwiderstand etwa einer anderen Zelle vorgenommen werden.

Hierbei tritt allerdings das Problem auf, daß die genannten Variationen in der Tunneloxiddicke selbst benachbarter Zellen zu Parameterschwankungen führen können, welche den zu messenden Unterschied im magnetoresistiven Widerstand in der Größenordnung von 10 - 20 % überwiegen können.

Alternativ kann auch ein direkt schaltendes Lesen angewandt werden. Dabei wird während der Strommessung zur Bestimmung des Speicherzellwiderstandes dieser so hoch eingeprägt, daß eine Ummagnetisierung, d.h. eine Umprogrammierung, des Zellinhaltes vorgenommen wird. Ändert sich dabei die Stromstärke aufgrund eines veränderten Widerstandes bei nun bekanntem Magnetisierungszustand der Zelle, so ist bekannt, wie der Zustand vor der Stromzuschaltung war. Entsprechendes gilt für den Fall, daß keine Änderung vorliegt. Durch die hohen Zellwiderstände bei geringer Spannung ergibt sich hierbei allerdings der Nachteil, daß die zu erwartende Stromänderung im Promillebereich liegt, und somit schwer zu detektieren ist. Vor allem aber ist diese Lesemethode destruktiv, d.h. bei Widerstandsänderung muß der Speicherzelleninhalt vor dem Lesevorgang wieder hergestellt werden.

Eine weitere Möglichkeit ist in DE 199 47 118 A1 beschrieben. Nacheinander werden zwei Spannungen jeweils in einer Kapazität gespeichert, deren Werte von den Widerständen in der Speicherzelle vor und nach einem Programmier- bzw. Schaltversuch abhängig sind. Die Spannungen können jeweils mit eigenen zusätzlichen Widerständen definiert werden, um z.B. einen Vergleich in einem Differenzverstärker zu ermöglichen. Nur für einen erfolgreichen Programmierversuch erhält man unterschiedliche, in den Kapazitäten gespeicherte Spannungen. Grundsätzlich entsteht aber auch hier ein Nachteil, daß nämlich durch zerstörende Lesemethoden der ursprüngliche Speicherinhalt wieder eingeschrieben werden muß, und daß durch das aufwendige Wiedereinlesen Zeit und Energie aufgebracht werden müssen. Desweiteren besteht in dieser Lösung der Nachteil, daß zwar Ströme durch nicht selektierte Wort- und Bitleitungen zu einer Reduktion parasitärer Effekte führen können, aber die Zellenfeldgröße dadurch zwangsläufig begrenzt ist.

US 5 477 482 offenbart die Merkmale des Obergriffs des Anspruchs 1.

Ausgehend vom genannten Stand der Technik liegt der vorliegenden Erfindung die Aufgabe zugrunde, einen Halbleiterspeicher mit magnetoresistiven Speicherzellen sowie ein Verfahren zum Betrieb des Halbleiterspeichers bereitzustellen, mit dem die beschriebenen Nachteile vermieden werden können. Insbesondere soll eine schnelle, genaue und sichere Bewertung einer Speicherzelle oder eines Speicherzellenfeldes unter Vermeidung parasitärer Effekte möglich werden.

Die Aufgabe wird gelöst durch den Halbleiterspeicher des Anspruchs 1, sowie durch ein Verfahren zum Betrieb dieses Halbleiterspeichers.

Weitere Ausgestaltungen der vorliegenden Erfindung sind in den abhängigen Unteransprüchen angegeben.

Die magnetoresistiven Speicherzellen umfassen TMR-Elemente (tunnel magnetoresistive) oder GMR-Elemente (giant magnetoresistive) oder ähnliche Speicherelemente, welche an Kreuzungspunkten der Wort- und Bitleitungen im Speicherzellenfeld jeweils zwischen diesen eingerichtet sind. Erfindungsgemäß umfassen diese Elemente eine hartmagnetische Schicht und eine weichmagnetische Schicht, welche z.B. durch eine dünne Tunneloxidbarriere als Isolatorschicht getrennt sind. Die hartmagnetische ferromagnetische Schicht besitzt die Eigenschaft eine Restmagnetisierung, die sog. Remanenz, bei Abschalten eines von außen angelegten Magnetfeldes aufzuweisen, d.h. es liegt eine magnetische Hysterese vor.

Die weichmagnetische, ferromagnetische Schicht ist durch schmale Hysteresekurven, d.h. durch nur geringe Remanenz und entsprechend kleiner Koerzitivfeldstärke bestimmt. Sie dient erfindungsgemäß daher nicht wie die hartmagnetische Schicht als Speicherschicht, welche durch Anlegen eines Magnetfeldes z.B. durch Stromfluß durch Wort- und/oder Bitleitung umgeschaltet werden kann, sondern als Sensorschicht zum Auslesen der in der hartmagnetischen Schicht gespeicherten Information, d.h der Ausrichtung der (Rest-)Magnetisierung in dieser Schicht. Eine mögliche, geringe Restmagnetisierung in der weichmagnetischen Schicht hat keinen Einfluß auf das Ausleseergebnis. Magnetisierungsänderungen in der weichmagnetischen Schicht durch externe Störfelder spielen daher vorteilhafter Weise kaum eine Rolle.

Die magnetischen Schichten weisen uniaxiale Anisotropie, d.h. jeweils leichte Magnetisierungsachsen, auf, bei denen die aktuelle Magnetisierungsrichtung entweder entlang der Achse in die eine oder in die dazu genau entgegengesetzte Richtung zeigt. Erfindungsgemäß schneiden sich die beiden Achsen der beiden Schichten in einer durch die Bit- und Wortleitungen definierten Ebene, liegen also nicht - wie im herkömmlichen Fall - parallel zueinander. Vorzugsweise stehen die Achsen senkrecht aufeinander. Die Magnetisierungsachse der weichmagnetischen Schicht ist derart ausgerichtet, daß die betreffende Magnetisierungsrichtung durch das äußere Magnetfeld, welches durch einen Stromfluß z.B. in der Wortleitung induziert wird, beeinflußt werden kann. Die Beeinflussung besteht in einer Auslenkung, d.h. Drehung, der Magnetisierungsrichtung in der weichmagnetischen Schicht aus der stabilen Konfiguration entlang der Magnetisierungsachse heraus. Die Magnetisierungsrichtung schließt dann einen Winkel mit der leichten bzw. mit der schweren Magnetisierungsachse, welche die labile Konfiguration der Magnetsierung bezeichnet, ein.

In einer vorteilhaften Ausgestaltung der vorliegenden Erfindung ist daher die Magnetisierungsachse der weichmagnetischen Schicht im wesentlichen parallel zur verbundenen Wortleitung angeordnet. Auch eine schrägwinkelige Anordnung ist möglich. Erst eine im wesentlichen senkrechte Anordnung der Magnetisierungsachse zur Wortleitung macht eine Auslenkung der aktuellen Magnetisierung in Winkelrichtung zur schweren Magnetisierungsachse unmöglich.

Es erschließt sich logisch, daß die Erfindung auch mit einer Anordnung funktioniert, bei der die o.g. Bitleitungen und Wortleitungen in ihrer Funktion wechselseitig ausgetauscht sind. Dieser Fall ist in der Erfindung mit eingeschlossen.

Die uniaxiale Anisotropie der Speicherschicht wird durch Abscheidung/Temperung im Magnetfeld und/oder die Form der Speicherelemente festgelegt. Insbesondere ist ein Antiferromagnet als sog. Pinning Layer nicht erforderlich.

Die Wirkung der Erfindung beruht auf der Detektion eines unterschiedlichen Widerstandes im Speicherelement beim Auslesen des Informationsgehaltes je nach Magnetisierungsrichtung in der hartmagnetischen Schicht bei Einprägung eines Stroms in z.B. die Wortleitung mit der Folge einer Magnetfeldänderung, welche unmittelbar auf die Magnetisierungsrichtung der weichmagnetischen Schicht einwirkt. Die Magnetisierungsrichtung der weichmagnetischen Schicht wird dadurch ausgelenkt, und zwar entweder in eine parallele oder in eine antiparallele Richtung relativ zur Magnetisierungsrichtung der hartmagnetischen Schicht. Entsprechend der relativen Ausrichtung ändert sich der magnetoresistive Widerstand des Elementes, welcher über eine Strom- oder Spannungsmessung ermittelt werden kann.

In einer weiteren, besonders vorteilhaften Ausgestaltung der vorliegenden Erfindung wird der über die Wortleitung eingeprägte Strom zeitlich variiert, vorzugsweise als Wechselstrom mit dem Verlauf einer Sinuskurve. Dieser erzeugt ein magnetisches Wechselfeld parallel zur schweren Magnetisierungsrichtung der Sensorschicht. Dadurch wird die Magnetisierung der weichmagnetischen Schicht aus der leichten Magnetisierungsrichtung in Phase mit dem Magnetfeld um einen Winkel ausgelenkt, welcher bei paralleler Anordnung von Magnetisierungsachse der weichmagnetische Schicht und der Wortleitung maximal 90 ° betragen kann.

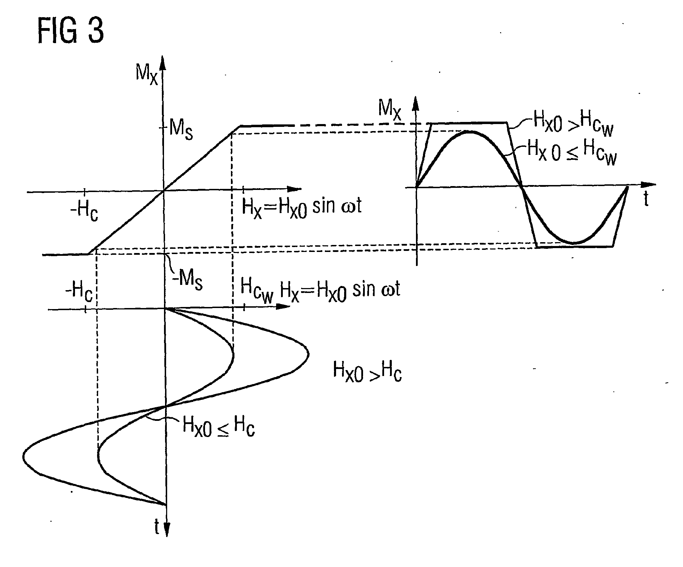

Da die Magnetisierungsänderung in schwerer Magnetisierungsrichtung linear und hysteresefrei ist, sind die Magnetisierung der weichmagnetischen Schicht und das äußere Magnetfeld in Phase. Die Magnetisierung der weichmagnetischen Schicht ändert sich für Feldamplituden unterhalb der Sättigungsfeldstärke (Koerzitivkraft, Anisotropiefeldstärke) ebenfalls sinusförmig, geht aber für diese Kraft übersteigende Feldamplituden in Sättigung über (siehe Figur 3), so daß ein rechteckförmiger Magnetisierungsverlauf entsteht. Auch die rechteckförmigen Signalverläufe können mit der vorliegende Erfindung ausgewertet werden, die Amplitude des zu messenden Strom- oder Spannungssignals kann jedoch für diese Kraft übersteigende Feldamplituden des Magnetfeldes nicht mehr erhöht werden.

Mit der Frequenz des Wechselstroms ändert sich infolgedessen auch der magnetoresistive Widerstand $R_{MR}$ mit:

$$R_{MR} = R_0 + \frac{1}{2}\Delta R(1 \pm \cos\alpha) = R_0 + \frac{1}{2}\Delta R(1 \pm \sin\varphi)$$

wobei die Zeichen + und - den beiden möglichen Zuständen der Magnetisierungsrichtung der hartmagnetischen Schicht entsprechen. $\alpha$ ist der von den Magnetisierungsrichtungen der harten und weichmagnetischen Schicht eingeschlossene Winkel, $\varphi = (\pi/2) - \alpha$ ist der Phasenwinkel des äußeren Magnetfeldes, $\Delta R$ bezeichnet den Unterschied im magnetoresistiven Widerstand zwischen Zuständen paralleler und antiparalleler Ausrichtung der Magnetisierungen und liegt typischerweise im Wertebereich von 10 % bis 30 % von $R_{MR}$.

Die Erhaltung der Speicherinformation in der hartmagnetischen Schicht ist gewährleistet, wenn die Feldamplitude des Wechselfeldes unterhalb der Koerzitivkraft dieser Schicht liegt. Da die Koerzitivkraft der hartmagnetischen Schicht wesentlich größer als die Koerzitivkraft der weichmagnetischen Schicht ist, bei welcher Größenordnung die Feldamplitude vorzugsweise gewählt wird, und da kein weiteres Magnetfeld bei der erfindungsgemäßen Auslesemethode auf das Speicherelement einwirkt, kann diese Bedingung leicht realisiert werden.

Die variierende Spannung bzw. der variierende Strom wird zum Auslesen auf beispielsweise die aktuell selektierte Wortleitung gegeben und mittels eines geeignet gewählten zusätzlichen Widerstandes, welcher wesentlich niedriger als der magnetoresistive Widerstand der Speicherzelle liegt, mit dem Grundpotential verbunden. Der Halbleiterspeicher umfaßt dazu eine entsprechende Wechselspannungs- bzw. -stromquelle. Durch diese Wahl des zusätzlichen Widerstandes wird ein möglichst geringe Rückwirkung des Stromflusses bzw. des Spannungsabfalles am Speicherelement auf das Signal in der Wortleitung und im Speicherlement gewährleistet.

Infolge der Gültigkeit der Beziehung $U_{MR} = I_{MR} \cdot R_{MR}$ ändert sich die durch eine Spannungsmeßeinrichtung im Halbleiterspeicher gemessene Spannung $U_{MR}$ zwischen Wort- und Bitleitung bzw. die am Speicherelement anliegende Spannung sowohl mit der Variation des Stromes $I_{MR}$ durch das Speicherelement als auch mit der Änderung des magnetoresistiven Widerstandes $R_{MR}$ des selektierten Speicherelementes. Diese Änderungen sind aber in Abhängigkeit von der parallelen oder antiparallelen Ausrichtung der Magnetisierungen gerade entweder in Phase oder gegenphasig. Somit entstehen für jede der beiden Ausrichtungsmöglichkeiten unterschiedliche Spannungssignale. Eine analoge Beziehung gilt für den Fall, daß der Strom durch das Speicherelement der magnetoresistiven Speicherzelle mittels einer Strommeßeinrichtung z.B. an der Bitleitung gemessen wird.

Die Erfindung soll nun an einem Ausführungsbeispiel anhand einer Zeichnung näher erläutert werden. Darin zeigen:

Figur 1    ein erfindungsgemäßes Ausführungsbeispiel eines Speicherzellenfeldes,

Figur 2    in Draufsicht auf eine Speicherzelle die Ausrichtung der Magnetisierungsachsen und Magnetfelder (a), und in Schrägansicht die Einstellungsmöglichkeiten sowie die erfindungsgemäße Auslenkung der Magnetisierung der weichmagnetischen Schicht (b),

Figur 3    ein Diagramm zur Darstellung der Abbildung des äußeren variierenden Magnetfeldes auf die Magnetisierung der weichmagnetischen Schicht,

Figur 4    jeweils einen Schaltplan für ein erfindungsgemäßes Ausführungsbeispiel mit in die Wortleitung eingespeistem Wechselstrom (a) beziehungsweise eingespeister Wechselspannung (b),

Figur 5    ein beispielhaftes Diagramm für eine am Speicherelement gemessene Wechselspannung, welche aus einem erfindungsgemäß in die Wortleitung eingespeisten Wechselstrom für zwei verschiedene Ausrichtungen der Magnetisierung der hartmagnetischen Schicht resultiert.

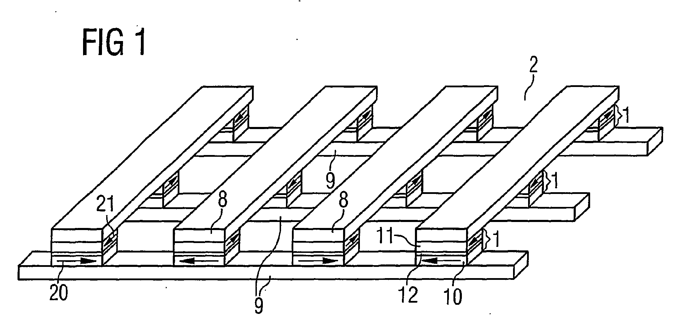

Eine erfindungsgemäße Anordnung von Speicherzellen 1 in einem Halbleiterspeicher 2, welche zwischen Wortleitungen 8 und Bitleitungen 9 angeordnet sind, ist in Fig. 1 zu sehen. Die Speicherzellen 1 beziehungsweise Speicherelemente mit tunnelmagnetoresistivem Widerstand (TMR-Elemente) umfassen eine harte ferromagnetische Schicht 10, eine Isolatorschicht 12, d.h. ein Tunneloxid, und eine weiche ferromagnetische Schicht 11. Die Richtungen der Magnetisierung 20, 21 sind - ohne einwirkende Magnetfelder - jeweils parallel zu den mit der Schicht verbundenen Wort- beziehungsweise Bitleitungen. Die Wortleitungen 8 stehen senkrecht auf den Bitleitungen 9, so daß auch die den aktuellen Richtungen der Magnetisierung entsprechenden leichten Magnetisierungsachen 30, 31 der harten 10 und weichen ferromagnetischen Schichten 11 senkrecht aufeinander stehen.

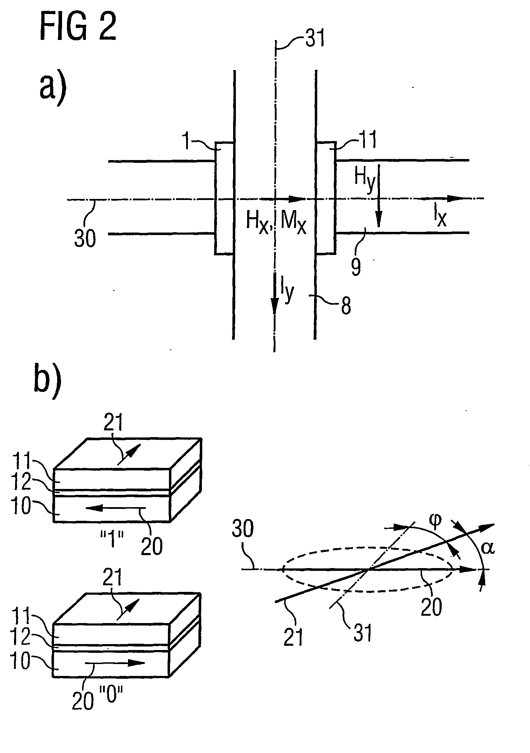

Die Information ist in der Richtung der Magnetisierung der harten ferromagnetischen Schicht 10 gespeichert. Beispielsweise entspricht einer Orientierung nach links in Fig. 2b eine logische "1" und einer Orientierung nach rechts eine logische "0". Die Ausrichtung 21 der ohnehin geringen Magnetisierung in der weichen ferromagnetischen Schicht 11 ist im stromfreien Fall zufällig und hat für die Speicherinformation zunächst keine Bedeutung.

Der Einfluß des aus einer Wechselstromquelle 50 in die Wortleitung 8 eingeprägten Wechselstroms $I_Y$ zum Auslesen des Speicherinhaltes ist in einer Draufsicht auf eine der Speicherzellen 1 in Fig. 2a dargestellt. Die Ausrichtung der Wortleitung 8 wird in diesem Ausführungsbeispiel als Y-Koordinate verstanden. Der Stromfluß $I_Y$ erzeugt ein Magnetfeld $\vec{H}_X$ unter anderem in der innerhalb der Draufsicht unter der Wortleitung 8 angeordneten weichen ferromagnetischen Schicht 11. Da die leichte Magnetisierungsachse 31 der weichmagnetischen Schicht 11 parallel zur Wortleitung 8 liegt, steht die Magnetfeldrichtung senkrecht zur leichten Magnetisierungsachse. Durch das äußere Magnetfeld $\vec{H}_X$ wird die Magnetisierungsrichtung 21 der weichmagnetischen schicht um den Winkel $\varphi$ aus der Position der leichten Magnetisierungsachse 31 ausgelenkt, wie in der schematischen Schrägsicht auf der rechten Seite in Fig. 2b zu erkennen ist.

In Fig. 3 ist die Abhängigkeit der schweren Magnetisierungskomponente $M_X$ der als Sensorschicht fungierenden weichmagnetischen Schicht von dem sinusförmigen magnetischen Wechselfeld $\vec{H}_X$ für zwei Fälle gezeigt. Im ersten Fall (fett gezeichnete Sinuskurve) ist die Amplitude $H_{X_0}$ des Magnetfeldes kleiner als die Koerzitivkraft der weichma-gnetischen Schicht, $H_{X_0} \leq H_{C_W}$, d.h. gleich der Anisotropiefeldstärke bei uniaxialer Anistropie. Die Stärke der Auslenkung der Magnetisierung ist dann ebenfalls sinusförmig.

Im zweiten Fall (dünn gezeichnete Sinuskurve) gilt $H_{X_0} > H_{C_W}$, und die Magnetisierung tritt in Sättigung ein, so daß ein rechteckförmiger Magnetisierungsverlauf entsteht.

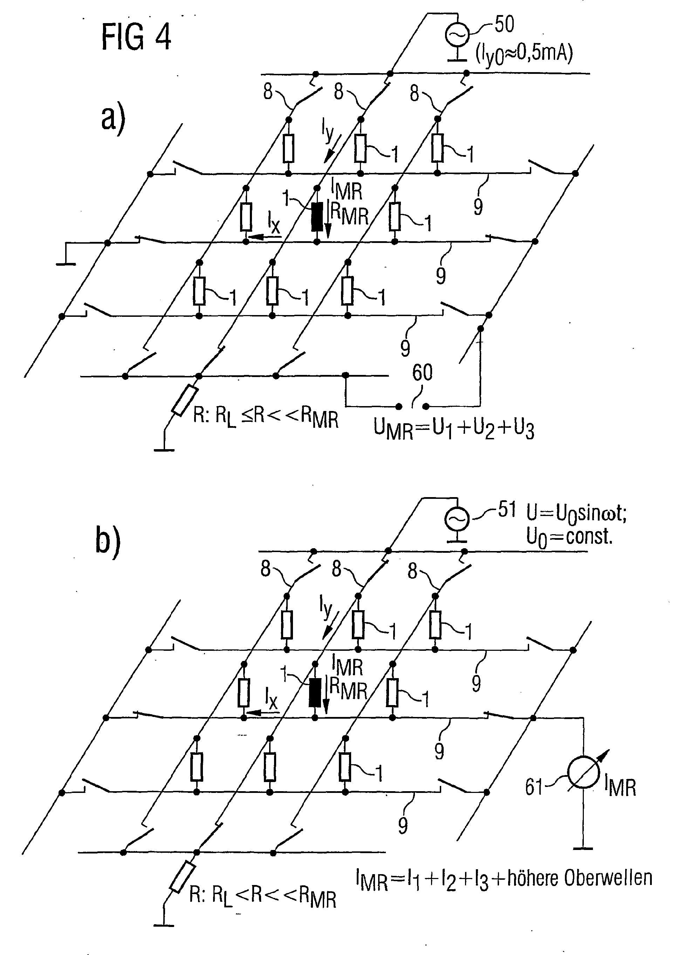

In Figur 4a ist ein Ausschnitt des TMR-Zellenfeldes des Ausführungsbeispieles als schematisches Schaltbild dargestellt. Zum Einschreiben von Information in den Speicher werden wie beim Stand der Technik Gleichstromimpulse hinreichender Größe und definierter Richtung durch die sich an dem selektierten Element kreuzenden Leiterbahnen geschickt. Bedingung für das Schreiben ist, daß das resultierende Magnetfeld die Schaltschwelle der hartmagnetischen Schicht überschreitet.

Das Auslesen des Informationsgehaltes der selektierten Speicherzelle erfolgt durch einen Wechselstrom

$$I_Y = I_{Y_0} \cdot \sin \omega t$$

mit konstanter Amplitude $I_{Y_0}$ durch die entsprechende Wortleitung 8, sowie die Analyse der Spannung zwischen den sich an der selektierten Speicherzelle kreuzenden Wort- 8 und Bitleitungen 9. Die nicht selektierten Leitungen sind sowohl von Wechselstromquelle 50 als auch von der Ausleseelektronik umfassend eine Spannungsmeßeinrichtung getrennt.

Durch den Strom Iywird die Magnetisierungsrichtung 21 der weichmagnetischen Schicht 11 moduliert, so daß sich mit dem gleichfalls variierenden Winkel zwischen den Magnetisierungsrichtungen 20, 21 der weichmagnetischen 11 und hartmagnetischen 10 Schicht der magnetoresistive Widerstand $R_{MR}$ sinusförmig ändert. Der tatsächlich durch das Speicherlement fließende Strom $I_{MR}$ steht in konstantem Verhältnis zum eingeprägten Strom $I_Y$, wenn z.B. der in Fig. 4a unten gezeigte zusätzliche Widerstand in der Schaltung in geeigneter Größe berücksichtigt wird. Die am Speicherelement abfallende Spannung beträgt damit

$$U_{MR} = c \cdot I_Y \cdot R_{MR} ,$$

wobei $c \approx R_L/R_0$, mit den beispielsgemäßen Werten für den Leiterbahnwiderstand $R_L \approx 1\ k\Omega$, sowie für den Mittelwert des magnetoresistiven Widerstandes $R_0 \approx 100\ k\Omega$.

Mit obigen Gleichungen ergibt sich

$$U_{MR} = c \cdot I_{Y_0} \cdot \sin \omega t \cdot \left( R_0 + \frac{1}{2} \Delta R (1 \pm \sin \omega t) \right)$$

$$U_{MR} = c I_{Y_0} R_0 \sin \omega t + \frac{1}{2} c I_{Y_0} \Delta R \sin \omega t \pm \frac{1}{2} c I_{Y_0} \Delta R \sin^2 \omega t$$

$$U_{MR} = \qquad U_1 + U_2 + U_3$$

mit den drei zu addierenden Spannungskomponenten:

$$U_1 = \pm \frac{c}{4} \cdot I_{Y_0} \cdot \Delta R$$

$$U_2 = c \cdot I_{Y_0} \left( R_0 + \frac{1}{2} \Delta R \right) \sin \omega t ,$$

$$U_3 = \mp \frac{c}{4} \cdot I_{Y_0} \cdot \Delta R \cdot \cos 2\omega t$$

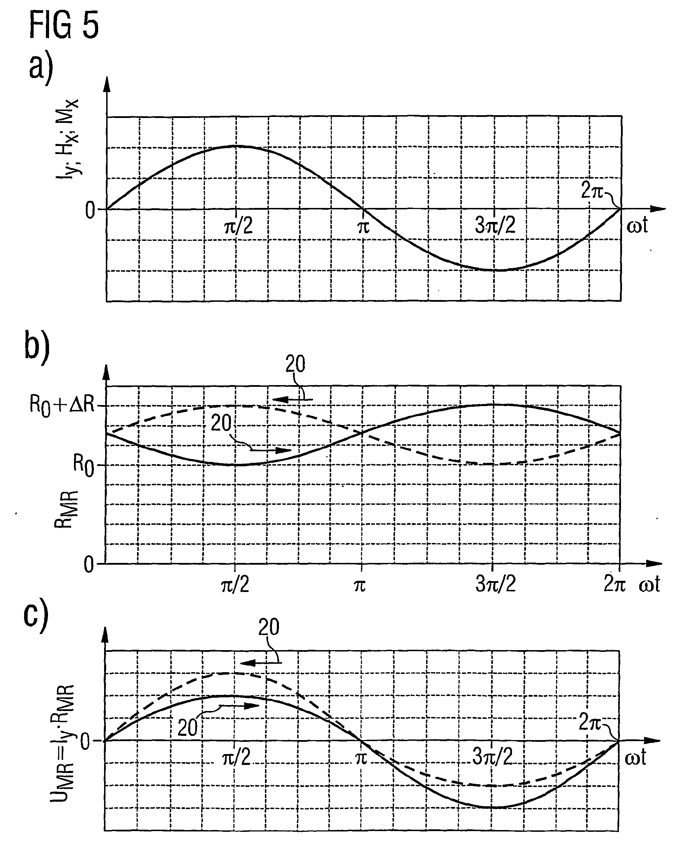

welche jeweils einen konstanten Spannungsbeitrag $U_1$, die Grundschwingung $U_2$ und eine erste Oberwelle $U_3$ darstellen. Durch den nichtlinearen magnetoresistiven Widerstand entsteht eine Gleichrichterwirkung, die zu einer Gleichspannungskomponente $U_1$ führt, deren Vorzeichen von der Magnetisierungsrichtung 20 in der hartmagnetischen Speicherschicht 10 und damit von der gespeicherten Information abhängt. Die Zeit- und Phasenabhängigkeiten der relevanten Größen sind in Fig. 5 für den Fall $H_{X_0} \leq H_{CW}$ dargestellt.

Die am Speicherelement anliegende Spannung $U_{MR}$ hat in der ersten und zweiten Halbperiode unterschiedliche Amplituden, wobei das Vorzeichen der resultierenden Gleichspannungskomponente von der Magnetisierungsrichtung 20 in der hartmagnetischen Speicherschicht 10 bestimmt wird. Dies ist in Fig. 5 jeweils durch die fett bzw. dünn gezeichneten Kurvenverläufe verdeutlicht.

Wird ein größeres Magnetfeld $H_X$ mit $H_{CH} > H_{X_0} > H_{CW}$ angelegt, wobei $H_{CH}$ die Koerzitivkraft der hartmagnetischen Schicht 10 ist, so geht die Magnetisierungskomponente $M_X$ der Magnetisierungsrichtung 21 der weichmagnetischen Schicht 11 in X-Richtung, also in Richtung der Bitleitung 9, in Sättigung über. Dann entsteht wie beschrieben ein rechteckförmiger Kurvenverlauf der Magnetisierungskomponente $M_X$ und des magnetoresitiven Widerstandes $R_{MR}$ . In diesem Fall läßt sich das Signal in eine höhere Zahl von weiteren Oberwellen zerlegen. Erfindungsgemäß kann aber auch dieser rechteckförmige Verlauf oder beliebige andere periodische Wechselsignale ausgewertet werden.

Durch die Bestimmung des Vorzeichens von $U_1$ kann vorteilhaft auf den Informationsgehalt der Zelle geschlossen werden. Die präzise Kenntnis des mittleren Zellwiderstandes $R_0$ sowie des magnetoresitiven Widerstandseffektes $\Delta R$ ist nicht notwendig. Für die Detektion in dem Ausführungsbeispiel wird die in Fig. 4a gezeigte Spannungsmeßeinrichtung benutzt.

Die Spannungskomponente $U_2$ enthält keine Information über den Speicherinhalt der Speicherzelle 1.

Die erste Oberwelle $U_3$ mit der doppelten Frequenz im Vergleich zur Grundschwingung hingegen enthält wiederum ein von der Magnetisierungsrichtung 20 der hartmagnetischen Schicht 10 abhängiges Vorzeichen. Wie bei $U_1$ ist die genaue Kenntnis des mittleren Zellwiderstandes $R_0$ sowie des magnetoresitiven Widerstandseffektes $\Delta R$ nicht erforderlich. Gemäß der vorliegenden Erfindung ist es hinreichend, das Vorzeichen oder die Phasenlage bezüglich Iy festzustellen.

Mit einem eingeprägten sinusförmigen Wechselstrom mit der Amplitude $I_{Y_0}$ = 1 mA und einem Verhältnis $\Delta R / R_0$ = 20 % ergibt sich für die Komponenten des Spannungsabfalls:

$$U_1 = 50 \text{mV}$$

$$U_2 = 1{,}1 \text{V} \qquad .$$

$$U_3 = 50 \text{mV}$$

Somit liegen die Beträge der zu detektierenden Signale in der Größenordnung von 5 % der Grundschwingung. Eine solche Messung ist daher technisch leicht durchführbar.

Der Anteil der Gleichspannungskomponente $U_1$ wird vom Wechselspannungsanteil $U_2$ durch Integration über eine Meßdauer von einer oder wenigen Schwingungsperioden getrennt, beziehungsweise hierdurch vom Gesamtsignal $U_{MR}$ abgeleitet. Bei einer Wechselstromfrequenz von 100 Mhz liegt die Meßdauer im vorliegenden Ausführungsbeispiel bei 10 Nanosekunden. Mittels RC-minimierter Leiterbahnen kann die Meßdauer noch niedriger ausgelegt werden. Andererseits kann durch längere Integrationszeiten das Signal-zu-Rausch-Verhältnis und damit die Auslesesicherheit erhöht werden. Die Verwendung von Tiefpässen, Verstärkern und/oder Komparatoren in der Spannungsmeßeinrichtung zum Auslesen des Informationsgehaltes ist dazu ebenfalls vorteilhaft.

Die erste Oberwelle $U_3$ kann durch phasenselektive Verstärkung, z.B. in sogenannter Lock-in-Technik detektiert werden. Auch diese Technik bietet die Möglichkeit hohe Signal-zu-Rausch-Verhältnisse zu erreichen.

In Fig. 4b ist für ein zum obigen Ausführungsbeispiel analoges weiteres Ausführungsbeispiel ein schematischer Schaltungsplan des Halbleiterspeichers dargestellt, bei dem eine Spannungsquelle 51 eine Wechselspannung in die Wortleitung 8 einprägt, während eine Strommeßeinrichtung 61 den Strom durch die Speicherzelle mißt. In ähnlicher Weise wie beim Spannungssignal ergeben sich auch hier für das zu messende Stromsignal wie in Fig. 5 Stromterme bestehend aus Gleichstrom, Grundschwingung und Oberwellen. Die Gleichstrom- bzw. Oberwellenterme sind vorzeichenbehaftet in Abhängigkeit von der Magnetisierungsrichtung 20 der hartmagnetischen Schicht 10 und werden in diesem Ausführungsbeispiel analog zum obigen Ausführungsbeispiel ausgelesen, anschließend vom Gesamtsignal $U_{MR}$ abgeleitet - etwa durch Integration, Tiefpässe, Komparatoren etc., und ausgewertet.

Durch die Erfindung entsteht der weitere Vorteil, daß parasitäre Effekte durch Kopplung der Speicherelemente 1 in der Widerstandsmatrix des Speicherzellenfeldes weitgehend ausgeschlossen werden. Ströme über Nebenschlußwiderstände werden durch die hohen Widerstände der TMR-Elemente stark reduziert.

Zusammenfassend gilt für die vorliegende Erfindung:

In dem Speicherzellenfeld eines Halbleiterspeichers 2 sind die Speicherelemente beziehungsweise Speicherzellen 1 mit magnetoresistivem Effekt durch eine hartmagnetische Speicherschicht 10 und eine weichmagnetische Sensorschicht 11 charakterisiert, deren leichte Magnetisierungsachsen 30, 31 sich schneiden. Die Magnetisierungsachse 30 der hartmagnetischen Schicht 10 liegt parallel zu der an ihr angeschlossenen Leitung, etwa der Bitleitung 9, und die Magnetisierungsachse 31 der weichmagnetischen Schicht liegt parallel zu der an ihr angeschlossenen Leitung, etwa der Wortleitung 8. Vorzugsweise stehen die Achsen mit den jeweils parallelen Leitungen im wesentlichen senkrecht aufeinander.

Über eine Wechselspannungs- 51 beziehungsweise Wechselstromquelle 50 wird ein Spannungs- bzw. Stromsignal auf eine jeweils selektierte Leitung, etwa die Wortleitung 8 geprägt. Die Magnetisierungsrichtung 21 der weichmagnetischen Schicht 11 wird dadurch sinusförmig aus der leichten Magnetisierungsachse 31 ausgelenkt. Neben dem eingeprägten Signal ändert sich dadurch auch der magnetoresistive Widerstand der Speicherzelle. Je nach Magnetisierungsrichtung 20 der hartmagnetischen Schicht 10 entsteht eine gleich- oder gegenphasige Überlagerung von Signal und Widerstand, so daß als Komponenten aus dem Signal z.B. eine vorzeichenbehaftete Gleichspannung sowie eine erste Oberwelle detektiert werden können. Das Vorzeichen liefert die Speicherinformation.

Bezugszeichenliste

| | |
|---|---|
| 1 | Speicherzelle, Speicherelement |
| 2 | Halbleiterspeicher |
| 8 | Wortleitung |
| 9 | Bitleitung |
| 10 | hartmagnetische Schicht |
| 11 | weichmagnetische Schicht |
| 12 | Isolatorschicht, Tunneloxid |
| 20 | Magnetisierungsrichtung der hartmagnetischen Schicht |
| 21 | Magnetisierungsrichtung der weichmagnetischen Schicht |
| 30 | Magnetisierungsachse der hartmagnetischen Schicht |
| 31 | Magnetisierungsachse der weichmagnetischen Schicht |
| 50 | Wechselstromquelle |
| 51 | Wechselspannungsquelle |
| 60 | Spannungsmeßeinrichtung |
| 61 | Strommeßeinrichtung |

**Patentansprüche**

1. Halbleiterspeicher (2) mit sich kreuzenden Wort- (8) und Bitleitungen (9), an denen magnetoresistive Speicherzellen (1) angeordnet sind, die jeweils umfassen:

   a) wenigstens eine aus hartem ferromagnetischem Material gebildete erste magnetische Schicht (10) mit einer ersten Magnetisierungsachse (30),
   b) eine aus weichem ferromagnetischem Material gebildet zweite magnetische Schicht (11) mit einer zweiten Magnetisierungsachse (31),
   c) eine zwischen den magnetischen Schichten (10, 11) angeordnete isolierende Schicht (12), wobei die erste (30) und zweite Magnetisierungsachse (31) sich schneiden, wenn sie in eine durch die Wort- (8) und die Bitleitung (9) aufgespannte Ebene projiziert werden,

   **dadurch gekennzeichnet, daß**

   - die zweite Magnetisierungsachse (31) der zweiten magnetischen Schicht (11) im wesentlichen parallel zu einer ersten der Wort- (8) oder Bitleitungen (9) angeordnet ist.

2. Halbleiterspeicher (2) nach Anspruch 1,
   **dadurch gekennzeichnet, daß**
   der magnetoresistive Widerstand auf dem tunnel-magnetoresistiven - TMR - Effekt der Kombination von Schichtmaterialien beruht.

3. Halbleiterspeicher nach Anspruch 1,
   **dadurch gekennzeichnet, daß**
   der magnetoresistive Widerstand auf dem groß-magnetoresistiven - GMR - Effekt der Kombination von Schichtmaterialien beruht.

4. Halbleiterspeicher nach einem der Ansprüche 1 bis 3,
   **dadurch gekennzeichnet, daß**
   die erste Magnetisierungsachse (30) der ersten magnetischen Schicht (10) im wesentlichen senkrecht zu der zweiten Magnetisierungsachse (31) angeordnet ist.

5. Halbleiterspeicher (2) nach einem der Ansprüche 1 - 4, **gekennzeichnet durch**
   eine Schaltungsanordnung zum Bewerten des Informationsgehalts wenigstens einer der magnetoresistiven Speicherzellen (1), umfassend

   - eine Wechselstromquelle (50), welche über eine Wortleitung (8) mit der Speicherzelle (1) verbunden ist,
   - eine Spannungsmeßeinrichtung (60), welche für eine Messung der Spannung mit der Wortleitung (8) und über eine Bitleitung (9) mit der Speicherzelle (1) verbunden ist, wobei die Speicherzelle (1) mit einem magnetoresistivem Widerstand zwischen die Wort- (8) und die Bitleitung (9) geschaltet ist.

6. Halbleiterspeicher (2) nach Anspruch 5,
   **dadurch gekennzeichnet, daß**

   - die an der Wechselstromquelle (50) angeschlossene Wortleitung (8) mit einem Grundpotential über einen zusätzlichen Widerstand verbunden ist, und
   - der Widerstand der magnetoresistiven Speicherzelle wenigstens die Größe des zusätzlichen Widerstandes besitzt.

7. Halbleiterspeicher (2) nach Anspruch 6,
   **dadurch gekennzeichnet, daß**

   - die Wortleitung (8) einen Leiterbahnwiderstand besitzt,
   - der Wert des zusätzlichen Widerstandes wenigstens den Wert des Leiterbahnwiderstandes besitzt.

8. Halbleiterspeicher (2) nach einem der Ansprüche 5 bis 7,
   **dadurch gekennzeichnet, daß**

die Spannungsmeßeinrichtung (60) eine Einheit zur Detektion eines Gleichspannungsanteils umfaßt.

9. Halbleiterspeicher (2) nach Anspruch 8,
   **dadurch gekennzeichnet, daß**
   die Einheit zur Detektion eines Gleichspannungsanteils wenigstens eines der Elemente aus einer Gruppe bestehend aus: Tiefpaß, Verstärker, Komparator, Integrationseinheit umfaßt.

10. Halbleiterspeicher (2) nach einem der Ansprüche 5 bis 9,
    **dadurch gekennzeichnet, daß**
    die Spannungsmeßeinrichtung (60) eine Einheit zur phasenselektiven Messung von Spannungsoberwellen umfaßt.

11. Halbleiterspeicher (2) nach einem der Ansprüche 1 - 5, **gekennzeichnet durch**
    eine Schaltungsanordnung zum Bewerten des Informationsgehalts wenigstens einer der magnetoresistiven Speicherzellen (1), umfassend

    - eine Wechselspannungsquelle (51), welche über eine Wortleitung (8) mit der Speicherzelle (1) verbunden ist,
    - eine Strommeßeinrichtung (61), welche für eine Messung des Stromflusses zwischen die Bitleitung (9) und einem Grundpotential geschaltet ist, wobei die eine Speicherzelle (1) mit einem magnetoresistivem Widerstand zwischen die Wort-(8) und die Bitleitung (9) geschaltet ist.

12. Halbleiterspeicher (2) nach Anspruch 11,
    **dadurch gekennzeichnet, daß**

    - die an der Wechselspannungsquelle (51) angeschlossene Wortleitung (8) mit einem Grundpotential über einen zusätzlichen Widerstand verbunden ist, und
    - der magnetoresistive Widerstand der Speicherzelle wenigstens die Größe des zusätzlichen Widerstandes besitzt.

13. Halbleiterspeicher (2) nach Anspruch 12,
    **dadurch gekennzeichnet, daß**

    - die Wortleitung (8) einen Leiterbahnwiderstand besitzt,
    - der zusätzliche Widerstand wenigstens den Wert des Leiterbahnwiderstandes besitzt.

14. Halbleiterspeicher (2) nach einem der Ansprüche 11 bis 13,
    **dadurch gekennzeichnet, daß**
    die Strommeßvorrichtung (61) eine Einheit zur Detektion eines Gleichstromanteils umfaßt.

15. Halbleiterspeicher (2) nach Anspruch 14,
    **dadurch gekennzeichnet, daß**
    die Einheit zur Detektion eines Gleichstromanteils wenigstens eines der Elemente aus einer Gruppe bestehend aus: Tiefpaß, Verstärker, Komparator, Integrationseinheit umfaßt.

16. Halbleiterspeicher nach einem der Ansprüche 11 bis 15,
    **dadurch gekennzeichnet, daß**
    die Strommeßvorrichtung (61) eine Einheit zur phäsenselektiven Messung von Stromflußoberwellen umfaßt.

17. Verfahren zum Betreiben des Halbleiterspeichers (2) nach einem der Ansprüche 1 bis 16 zur Bewertung des Informationsgehaltes wenigstens einer der magnetoresistiven Speicherzellen (1), umfassend die Schritte:

    - Einspeisung eines Wechselstroms oder einer Wechselspannung mit konstanter Frequenz und Amplitude in die mit der zu bewertenden Speicherzelle (1) verbundenen Wortleitung (8),
    - Messung eines Signals während einer Meßdauer, welches

        a) entweder aus der Stärke des Stromflusses durch die Abfolge von Schichten (10, 11, 12) der Speicherzelle (1) mit magnetoresistivem Widerstand mittels einer Strommeßeinrichtung (61)
        b) oder aus der Spannung zwischen der Bit- (9) und der Wortleitung (8) mittels einer Spannungsmeßeinrichtung (60)

abgeleitet wird,
- Bewerten des Informationsgehaltes der Speicherzelle (1) in Abhängigkeit vom Verlauf des Signales während der Meßdauer.

**18.** Verfahren nach Anspruch 17,
**dadurch gekennzeichnet, daß**

- das in der Strom- (61) oder Spannungsmeßeinrichtung (60) aus der Messung abgeleitete Signal den Gleichstrom- oder Gleichspannungsanteil des gemessenen Wechselstrom- oder Wechselspannungsverlaufes beinhaltet,
- die Bewertung in Abhängigkeit vom Vorzeichen des Gleichstrom- oder Gleichspannungsanteiles durchgeführt wird.

**19.** Verfahren nach Anspruch 17 oder 18,
**dadurch gekennzeichnet, daß**

- das in der Strom- (61) oder Spannungsmeßeinrichtung (60) aus der Messung abgeleitete Signal die erste Oberwelle des Wechselstrom- oder Wechselspannungsverlaufes mit dem Zweifachen der eingespeisten Wechselstrom- oder Wechselspannungsfrequenz beinhaltet,
- die Bewertung in Abhängigkeit vom Vorzeichen der Oberwelle bei vorgegebener Phase durchgeführt wird.

**20.** Verfahren nach Anspruch 19,
**dadurch gekennzeichnet, daß**
eine phasenselektive Lock-In-Technik verwendet wird.

**21.** Verfahren nach einem der Ansprüche 17 bis 20,
**dadurch gekennzeichnet, daß**
die Meßdauer weniger als 20 Nanosekunden beträgt.

**22.** Verfahren nach einem der Ansprüche 17 bis 21,
**dadurch gekennzeichnet, daß**
die Wechselstrom- oder Wechselspannungsfrequenz mehr als 100 Megahertz beträgt.

**Claims**

**1.** Semiconductor memory (2) having mutually crossing word (8) and bit lines (9), at which magnetoresistive memory cells (1) are arranged, which in each case comprise:

a) at least a first magnetic layer (10) formed from hard ferromagnetic material and having a first magnetization axis (30),
b) a second magnetic layer (11) formed from soft ferromagnetic material and having a second magnetization axis (31),
c) an insulating layer (12) arranged between the magnetic layers (10, 11), the first (30) and the second magnetization axis (31) intersecting if they are projected into a plane spanned by the word (8) and the bit line (9),

**characterized in that**

- the second magnetization axis (31) of the second magnetic layer (11) is arranged essentially parallel to a first of the word (8) or bit lines (9).

**2.** Semiconductor memory (2) according to claim 1,
**characterized in that**
the magnetoresistive resistance is based on the tunnel magnetoresistive - TMR - effect of the combination of layer materials.

**3.** Semiconductor memory according to claim 1,
**characterized in that**

the magnetoresistive resistance is based on the giant magnetoresistive - GMR - effect of the combination of layer materials.

4. Semiconductor memory according to one of claims 1 to 3,
   **characterized in that**
   the first magnetization axis (30) of the first magnetic layer (10) is arranged essentially perpendicular to the second magnetization axis (31).

5. Semiconductor memory (2) according to one of claims 1 - 4,
   **characterized by**
   a circuit arrangement for evaluating the information content of at least one of the magnetoresistive memory cells (1), comprising

   - an AC current source (50), which is connected to the memory cell (1) via a word line (8),
   - a voltage measuring device (60), which is connected, for a measurement of the voltage, to the word line (8) and, via a bit line (9), to the memory cell (1), the memory cell (1) being connected with a magnetoresistive resistance between the word (8) and the bit line (9).

6. Semiconductor memory (2) according to claim 5,
   **characterized in that**

   - the word line (8) connected to the AC current source (50) is connected to a ground potential via an additional resistance, and
   - the resistance of the magnetoresistive memory cell has at least the magnitude of the additional resistance.

7. Semiconductor memory (2) according to claim 6,
   **characterized in that**

   - the word line (8) has an interconnect resistance,
   - the value of the additional resistance has at least the value of the interconnect resistance.

8. Semiconductor memory (2) according to one of claims 5 to 7,
   **characterized in that**
   the voltage measuring device (60) comprises a unit for detecting a DC voltage component.

9. Semiconductor memory (2) according to claim 8,
   **characterized in that**
   the unit for detecting a DC voltage component comprises at least one of the elements from a group consisting of: low-pass filter, amplifier, comparator, integration unit.

10. Semiconductor memory (2) according to one of claims 5 to 9,
    **characterized in that**
    the voltage measuring device (60) comprises a unit for the phase-selective measurement of voltage harmonics.

11. Semiconductor memory (2) according to one of claims 1 - 5,
    **characterized by**
    a circuit arrangement for evaluating the information content of at least one of the magnetoresistive memory cells (1), comprising

    - an AC voltage source (51), which is connected to the memory cell (1) via a word line (8),
    - a current measuring device (61), which is connected for a measurement of the current flow between the bit line (9) and a ground potential, one memory cell (1) being connected with a magnetoresistive resistance between the word (8) and the bit line (9).

12. Semiconductor memory (2) according to claim 11,
    **characterized in that**

    - the word line (8) connected to the AC voltage source (51) is connected to a ground potential via an additional resistance, and
- the magnetoresistive resistance of the memory cell has at least the magnitude of the additional resistance.

**13.** Semiconductor memory (2) according to claim 12,
   **characterized in that**

   - the word line (8) has an interconnect resistance,
   - the additional resistance has at least the value of the interconnect resistance.

**14.** Semiconductor memory (2) according to one of claims 11 to 13,
   **characterized in that**
   the current measuring device (61) comprises a unit for detecting a DC current component.

**15.** Semiconductor memory (2) according to claim 14,
   **characterized in that**
   the unit for detecting a DC current component comprises at least one of the elements from a group consisting of:
   low-pass filter, amplifier, comparator, integration unit.

**16.** Semiconductor memory according to one of claims 11 to 15,
   **characterized in that**
   the current measuring device (61) comprises a unit for the phase-selective measurement of current flow harmonics.

**17.** Method for operating the semiconductor memory (2) according to one of claims 1 to 16, for evaluating the information content of at least one of the magnetoresistive memory cells (1), comprising the steps of:

   - feeding an AC current or an AC voltage having constant frequency and amplitude into the word line (8) connected to the memory cell (1) to be evaluated,
   - measuring a signal during a measurement duration, which signal is derived

      a) either from the intensity of the current flow through the sequence of layers (10, 11, 12) of the memory cell (1) with a magnetoresistive resistance by means of the current measuring device (61)
      b) or from the voltage between the bit (9) and the word line (8) by means of the voltage measuring device (60),

   - evaluation of the information content of the memory cell (1) in a manner dependent on the profile of the signal during the measurement duration.

**18.** Method according to claim 17,
   **characterized in that**

   - the signal derived from the measurement in the current (61) or voltage measuring device (60) comprises the DC current or DC voltage component of the measured AC current or AC voltage profile,
   - the evaluation is carried out in a manner dependent on the sign of the DC current or DC voltage component.

**19.** Method according to claim 17 or 18,
   **characterized in that**

   - the signal derived from the measurement in the current (61) or voltage measuring device (60) comprises the first harmonic of the AC current or AC voltage profile with double the AC current or AC voltage frequency fed in,
   - the evaluation is carried out in a manner dependent on the sign of the harmonic in the case of a predetermined phase.

**20.** Method according to claim 19,
   **characterized in that**
   a phase-selective lock-in technique is used.

**21.** Method according to one of claims 17 to 20,
   **characterized in that**
   the measurement duration is less than 20 nanoseconds.

**22.** Method according to one of claims 17 to 21,
**characterized in that**
the AC current or AC voltage frequency is more than 100 megahertz.

**Revendications**

**1.** Mémoire (2) à semi-conducteur comprenant des lignes (8) de mots et des lignes (9) de bits qui s'entrecroisent et sur lesquelles sont disposées des cellules (1) de mémoire magnétorésistives qui comprennent, respectivement :

a) au moins une première couche (10) magnétique en un matériau ferromagnétique dur et ayant un premier axe (30) de magnétisation,
b) une deuxième couche (11) magnétique en un matériau ferromagnétique (12) et ayant un deuxième axe (31) de magnétisation,
c) une couche (12) isolante disposée entre les couches (10, 11) magnétiques, le premier axe (30) et le deuxième axe (31) de magnétisation se coupant lorsqu'ils sont projetés dans un plan passant par la ligne (8) de mots et par la ligne (9) de bits,

**caractérisée en ce que**

- le deuxième axe (31) d'aimantation de la deuxième couche (11) magnétique est sensiblement parallèle à une première des lignes (8) de mots ou des lignes (9) de bits.

**2.** Mémoire (2) à semi-conducteur suivant la revendication 1,
**caractérisée en ce que**
la résistance magnétorésistive repose sur l'effet magnétorésistif tunnel-TMR de la combinaison des matériaux de couches.

**3.** Mémoire (2) à semi-conducteur suivant la revendication 1,
**caractérisée en ce que**
la résistance magnétorésistive repose sur l'effet de grande magnétorésistivité-GMR-de la combinaison des matériaux de couches.

**4.** Mémoire (2) à semi-conducteur suivant l'une des revendications 1 à 3,
**caractérisée en ce que**
le premier axe (30) de magnétisation de la première couche (10) magnétique est sensiblement perpendiculaire au deuxième axe (31) de magnétisation.

**5.** Mémoire (2) à semi-conducteur suivant l'une des revendications 1 à 4,
**caractérisée par**
un montage d'évaluation de la teneur informative d'au moins l'une des cellules (1) de mémoire magnétorésistive, comprenant

- une source (50) de courant alternatif qui est reliée à la cellule (1) de mémoire par une ligne (8) de mots,
- un dispositif (60) de mesure de la tension qui, pour mesurer la tension, est reliée à la ligne (8) de mots et par une ligne (9) de bits à la cellule (1) de mémoire, la cellule (1) de mémoire ayant une résistance magnétorésistive étant montée entre la ligne (8) de mots et la ligne (9) de bits.

**6.** Mémoire (2) à semi-conducteur suivant la revendication 5,
**caractérisée en ce que**

- la ligne (8) de mots reliée à la source (50) de courant alternatif est reliée à un potentiel de base par une résistance supplémentaire,
- la résistance de la cellule de mémoire magnétorésistive a au moins la valeur de la résistance supplémentaire.

**7.** Mémoire (2) à semi-conducteur suivant la revendication 6,
**caractérisée en ce que**

- la ligne (8) de mots a une résistance de piste conductrice,
- la valeur de la résistance supplémentaire a au moins la valeur de la résistance de piste conductrice.

8. Mémoire (2) à semi-conducteur suivant l'une des revendications 5 à 7,
   **caractérisée en ce que**
   le dispositif (60) de mesure de la tension comprend une unité de détection d'une composante de tension continue.

9. Mémoire (2) à semi-conducteur suivant la revendication 8,
   **caractérisée en ce que**
   l'unité de détection d'une composante de tension continue comprend au moins l'un des éléments parmi un groupe constitué de : un passe-bas, un amplificateur, un comparateur, une unité d'intégration.

10. Mémoire (2) à semi-conducteur suivant l'une des revendications 5 à 9,
    **caractérisée en ce que**
    le dispositif (60) de mesure de la tension comprend une unité de mesure sélective en phase d'harmoniques de tension.

11. Mémoire (2) à semi-conducteur suivant l'une des revendications 1 à 5,
    **caractérisée par**
    un montage d'évaluation de la teneur informative d'au moins l'une des cellules (1) de mémoire magnétorésistives, comprenant

    - une source (51) de tension alternative qui est reliée à la cellule (1) de mémoire par une ligne (8) de mots,
    - un dispositif (61) de mesure du courant qui est monté, pour une mesure du flux de courant, entre la ligne (9) de bits et un potentiel de base, la une cellule (1) de mémoire ayant une résistance magnétorésistive étant montée entre la ligne (8) de mots et la ligne (9) de bits.

12. Mémoire (2) à semi-conducteur suivant la revendication 11,
    **caractérisée en ce que**

    - la ligne (8) de mots reliée à la source (51) de tension alternative est reliée à un potentiel de base par une résistance supplémentaire, et
    - la résistance magnétorésistive de la cellule de mémoire a au moins la valeur de la résistance supplémentaire.

13. Mémoire (2) à semi-conducteur suivant la revendication 12,
    **caractérisée en ce que**

    - la ligne (8) de mots a une résistance de piste conductrice,
    - la valeur de la résistance supplémentaire a au moins la valeur de la résistance de piste conductrice.

14. Mémoire (2) à semi-conducteur suivant l'une des revendications 11 à 13,
    **caractérisée en ce que**
    le dispositif (61) de mesure de la tension comprend une unité de détection d'une composante de courant continu.

15. Mémoire (2) à semi-conducteur suivant la revendication 14,
    **caractérisée en ce que**
    l'unité de détection d'une composant de courant continu comprend au moins l'un des éléments parmi un groupe constitué de : un passe-bas, un amplificateur, un comparateur, une unité d'intégration.

16. Mémoire (2) à semi-cônducteur suivant l'une des revendications 11 à 15,
    **caractérisée en ce que** le dispositif (61) de mesure de la tension comprend une unité de mesure sélective en phase d'harmoniques de tension.

17. Procédé pour faire fonctionner la mémoire (2) à semi-conducteur suivant l'une des revendications 1 à 16 pour évaluer la teneur informative d'au moins l'une des cellules (1) de mémoire magnétorésistives, comprenant les stades dans lesquels :

    - on applique un courant alternatif ou une tension alternative de fréquence et d'amplitude constantes à la ligne (8) de mots reliée à la cellule (1) de mémoire à évaluer,

- on mesure un signal pendant une durée de mesure, qui

    a) est déduit soit de l'intensité du flux de courant passant dans la succession de couches (10, 11, 12) de la cellule (1) de mémoire ayant une résistance magnétorésistive au moyen d'un dispositif (61) de mesure du courant

    b) ou, à partir de la tension entre la ligne (9) de bits et la ligne (8) de mots, au moyen d'un dispositif (60) de mesure de la tension,

- on évalue la teneur informative de la cellule (1) de mémoire en fonction de la variation du signal pendant la durée de mesure.

**18.** Procédé suivant la revendication 17,
    **caractérisé en ce que**

    - le signal déduit de la mesure dans le dispositif (61) de mesure du courant ou dans le dispositif (60) de mesure de la tension contient la composante de courant continu ou la composante de tension continue de la courbe mesurée de courant alternatif ou de tension alternative,
    - on effectue l'évaluation en fonction du signal de la composante de courant continu ou de la composante de tension continue.

**19.** Procédé suivant la revendication 17 ou 18,
    **caractérisé en ce que**

    - le signal déduit de la mesure dans le dispositif (61) de mesure du courant ou dans le dispositif (60) de mesure de la tension contient le premier harmonique de la courbe de courant alternatif ou de tension alternative ayant le double de la fréquence du courant alternatif ou de la tension alternative appliquée,
    - on effectue l'évaluation en fonction du signe de l'harmonique pour une phase prescrite.

**20.** Procédé suivant la revendication 19,
    **caractérisé en ce que**
    l'on utilise une technique Lock-In sélective en phase.

**21.** Procédé suivant l'une des revendications 17 à 20,
    **caractérisé en ce que**
    la durée de mesure est inférieure à 20 nanosecondes.

**22.** Procédé suivant l'une des revendications 17 à 20,
    **caractérisé en ce que**
    la fréquence du courant alternatif ou de la tension alternative est supérieure à 100 Megahertz.

# FIG 1

# FIG 2

## a)

## b)

FIG 3

# FIG 4

a)

50
($I_{y0} \approx 0{,}5\,mA$)

8   8   8

$I_y$

1   1

$I_{MR}$
$R_{MR}$

1

1   $I_x$   1

9

1

9

1   1   1

9

60

R: $R_L \leq R \ll R_{MR}$

$U_{MR} = U_1 + U_2 + U_3$

b)

51   $U = U_0 \sin\omega t$;
$U_0 = const.$

8   8   8

$I_y$

1   1

$I_{MR}$
$R_{MR}$

1

1   $I_x$   1

9

1

9

1   1   1

9

61   $I_{MR}$

R: $R_L < R \ll R_{MR}$

$I_{MR} = I_1 + I_2 + I_3 + höhere\ Oberwellen$

# FIG 5

## a)

## b)

## c)